(19) Europäisches Patentamt
European Patent Office
Office européen des brevets

(11) **EP 4 703 740 A1**

(12) **EUROPEAN PATENT APPLICATION**

(43) Date of publication:
**04.03.2026 Bulletin 2026/10**

(21) Application number: **25187838.5**

(22) Date of filing: **07.07.2025**

(51) International Patent Classification (IPC):
**G01R 29/10** (2006.01)    **H04B 17/12** (2015.01)

(52) Cooperative Patent Classification (CPC):
**G01R 29/10; H04B 17/12**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **30.08.2024 US 202418821450**

(71) Applicant: **Rohde & Schwarz GmbH & Co. KG
81671 München (DE)**

(72) Inventor: **Hungrichhaussen, Horst
81671 München (DE)**

(74) Representative: **Prinz & Partner mbB
Patent- und Rechtsanwälte
Rundfunkplatz 2
80335 München (DE)**

(54) **METHOD AND MEASUREMENT ARRANGEMENT FOR DETERMINING AN ANTENNA FACTOR OF A MONOPOLE ANTENNA**

(57)     The invention relates to a method for determining an antenna factor of a monopole antenna (42). A universal artificial antenna (14) is provided and its coupling capacitance is determined. A matching device (30) is connected with the universal artificial antenna (14), wherein a scattering parameter associated with the universal artificial antenna (14) is measured. A calibration adapter (16) replaces the universal artificial antenna (14), wherein a scattering parameter associated with the calibration adapter (16) is measured. An input capacitance of the matching device (30) is determined. A monopole antenna (42) is connected with the matching device (30) and the universal artificial antenna (14), wherein a scattering parameter associated with the universal artificial antenna (14) and a scattering parameter associated with the calibration adapter (16) are measured. The calibration adapter (16) replaces the universal artificial antenna (14). A capacitance of the monopole antenna (42) is calculated. The antenna factor is determined based on the capacitance of the monopole antenna (42), the coupling capacitance of the universal artificial antenna (14) and the input capacitance of the matching device (30). A measurement arrangement is shown.

Fig. 11

S1 — Providing universal artificial antenna and determining a coupling capacity

S2 — Providing matching device connected to matching device and measuring scattering parameter associated with the universal artificial antenna

S3 — Providing calibration adapter connected to matching device and measuring scattering parameter associated with the calibration adapter

S4 — Determining an input capacitance of the matching device

S5 — Providing monopole antenna connected to universal artificial antenna and measuring scattering parameter associated with universal artificial antenna

S6 — Providing monopole antenna connected to calibration adapter and measuring scattering parameter associated with calibration adapter

S7 — Determining capacitance of monopole antenna

S8 — Determining antenna factor of monopole antenna based on coupling capacitance of universal artificial antenna and input capacitance of matching device

**Description**

FIELD OF THE DISCLOSURE

Embodiments of the invention relate to a method for determining an antenna factor of a monopole antenna. Further, embodiments of the invention relate to a measurement arrangement for determining an antenna factor of a monopole antenna.

BACKGROUND

Monopole antennas are inter alia used for radiated emission measurements. In many fields, such as electromagnetic compliance testing, EMC testing, the accuracy of the calibration of a monopole antenna plays an important role. It is therefore necessary to determine an antenna factor and calibrate the monopole antenna accordingly.
In the state of the art, many methods are known for determining the antenna factor of a monopole antenna. One of the most common methods for determining the antenna factor and for calibrating a monopole antenna is the equivalent capacitance substitution method, ECSM. In this method, the monopole antenna is calibrated using an artificial antenna with a capacitor equal to a self-capacitance of the monopole antenna. The monopole antenna is thus replaced by the capacitor. A capacitance of the monopole antenna is then calculated by a formula according to DIN EN 55016-1-6.
However, for determining the antenna factor using the ECSM method, it is important that the artificial antenna matches the monopole antenna, or more precisely, that the capacitor of the artificial antenna has the same capacitance as the monopole antenna. Additionally, the capacitance of the capacitor of the artificial antenna must be known in advance in order to determine the antenna factor of the monopole antenna.
Another disadvantage of the ECSM is that it has limited ability to correct an effective height of the monopole antenna if the monopole antenna is not mounted directly on the ground, but there is a distance between the monopole antenna and the ground, is only possible to a limited extend.
Accordingly, there is a need for an improved method of calculating an antenna factor of a monopole antenna and for calibrating the monopole antenna accordingly.

SUMMARY

The following summary of the invention is intended to introduce different concepts in a simplified form that are described in further detail in the detailed description provided below. This summary is neither intended to denote essential features of the invention nor shall this summary be used as an aid in determining the scope of the claimed subject matter.
Embodiments of the invention provide a method for determining an antenna factor of a monopole antenna. The method comprising the following steps:

- providing a universal artificial antenna and determining a coupling capacitance of the universal artificial antenna in a first measurement setup;
- providing a matching device, connecting the matching device with the universal artificial antenna, thereby obtaining a second measurement setup, and measuring a scattering parameter associated with the universal artificial antenna in the second measurement setup,
- providing a calibration adapter, connecting the matching device with the calibration adapter such that the calibration adapter replaces the universal artificial antenna, thereby obtaining a third measurement setup, and measuring a scattering parameter associated with the calibration adapter in the third measurement setup,
- determining an input capacitance of the matching device using the ratio of the scattering parameter associated with the universal artificial antenna in the second measurement setup to the scattering parameter associated with the calibration adapter in the third measurement setup;
- providing a monopole antenna, connecting the monopole antenna with the matching device and the universal artificial antenna, thereby obtaining a fourth measurement setup, and measuring a scattering parameter associated with the universal artificial antenna in the fourth measurement setup;
- providing the calibration adapter, connecting the monopole antenna with the matching device and the calibration adapter such that the calibration adapter replaces the universal artificial antenna, thereby obtaining a fifth measurement setup, and measuring a scattering parameter associated with the calibration adapter in the fifth measurement setup;
- determining a capacitance of the monopole antenna based on the coupling capacitance of the universal artificial antenna, the input capacitance of the matching device, and the ratio of the scattering parameter associated with the universal artificial antenna in the fourth measurement setup to the scattering parameter associated with the calibration adapter in the fifth measurement setup; and

- determining the antenna factor of the monopole antenna based on the capacitance of the monopole antenna, the coupling capacitance of the universal artificial antenna and the input capacitance of the matching device.

Moreover, embodiments of the invention provide a measurement arrangement for determining an antenna factor of a monopole antenna. The measurement arrangement having different measurement setups, wherein the measurement arrangement comprises a universal artificial antenna, a calibration adapter, a matching device, a monopole antenna and a network analyser, which can be arranged differently so as to obtain the different measurement setups.

In a first measurement setup for determining the capacitance of the universal artificial antenna, the universal artificial antenna is coupled to the calibration adapter.

In a second measurement setup for measuring the scattering parameter associated with the universal artificial antenna, the matching device is coupled to the universal artificial antenna, wherein the matching device and the artificial antenna are coupled to the network analyzer.

In a third measurement setup for measuring the scattering parameter associated with the calibration adapter, the matching device is coupled to the calibration adapter, wherein the matching device and the calibration adapter are coupled to the network analyzer.

In a fourth measurement setup for measuring the scattering parameter associated with the universal artificial antenna, the matching device is coupled to the monopole antenna, wherein the universal artificial antenna is coupled to the monopole antenna, and wherein the universal artificial antenna and the matching device are coupled to the network analyzer.

In a fifth measurement setup for measuring the scattering parameter associated with the calibration adapter, wherein the matching device is coupled to the monopole antenna, wherein the calibration adapter is coupled to the monopole antenna, and wherein the calibration adapter and the matching device are coupled to the network analyzer.

These in total five measurement setups are needed, to determine the different scattering parameters, based on which the different capacitances can be calculated so as to finally determine the antenna factor of the monopole antenna and to calibrate the monopole antenna accordingly.

The hardware may, inter alia, comprise a CPU, a GPU, an FPGA, an ASIC, or other types of electronic circuitry.

Therein, the term "connecting A with B" is understood to denote that an electrically conductive connection is provided between A and B, such that a signal transmission between A and B via an electrical conductor can be established, for instance via a line, a cable, or a wire.

Likewise, the term "connect" is understood to denote an electrically conductive connection via an electrical conductor, particularly without interruption, e.g. a continuous electrical conductor.

The term "coupled to" is understood to denote an electrically conductive connection via an electrical conductor and, thus, it is synonymous to the term "connected to".

Further, the term "universal artificial antenna" is understood to denote any type of artificial antenna, which does not have to be adjusted to the monopole antenna. In specific, resistors of the universal artificial antenna do not have to equal to the self-capacitance of the monopole antenna.

In addition, the term "monopole antenna" is understood to denote monopole antennas of various shapes, such as a rod of a specific length or height and/or a specific diameter, or any other type of monopole antenna. The monopole antennas can be mounted on the ground or on a ground plate that is distant from the ground. If the monopole antenna is mounted on a ground plate distanced from the ground, the monopole antenna must be grounded by an appropriate grounding line.

"Scattering parameters" are known and describe the electrical behaviour of linear electrical networks when undergoing various steady state stimuli by electrical signals, namely a proportion of an incident wave and a reflected wave. For instance, a scattering parameter, S-parameter, of a two-port network has the following generic descriptions: $S_{11}$ is the input port voltage reflection coefficient, $S_{12}$ is the reverse voltage gain, $S_{21}$ is the forward voltage gain and $S_{22}$ is the output voltage reflection coefficient.

The expression "measuring a scattering parameter" is understood to denote that the scattering parameter is determined based on measured parameters, for instance based on the incident wave and the reflected wave.

The method according to the invention is based on the idea that the antenna factor of a monopole antenna can be calculated in a few steps using different measurement setups, also called measurement arrangements, wherein the calculation can be attributed (solely) to scattering parameters measured in different measurement setups. Depending on the measurement setup, the respective scattering parameters measured can be used to determine the capacitance of the monopole antenna, the input capacitance of the matching device and/or the coupling capacitance of the universal artificial antenna, wherein these parameters are taken into account when determining the antenna factor. In other words, measured scattering parameters directly or values calculated based on measured scattering parameters, e.g. the input capacitance of the matching device and/or the capacitance of the monopole antenna, are used in order to calculate the antenna factor and to calibrate the monopole antenna.

The method of the invention has the advantage that the universal artificial antenna does not have to match with the monopole antenna, leading to the advantage that one universal artificial antenna can be used to calibrate various monopole antennas. In addition, the capacitance of the universal artificial antenna is independent of characteristics such as the diameter or the length of the monopole antenna.

As indicated above, the calculation is based on scattering parameters, resulting in smaller uncertainties in the antenna factor calculation. Consequently, the antenna factor can be determined for different positions, e.g. different heights with respect to ground.

In addition, the method can be used to determine the capacitance of a rod of the monopole antenna and the antenna factor can be determined for different heights of the monopole antenna.

Generally, the respective measurements can be performed by means of a network analyser, namely the measurements of the scattering parameters, particularly in the different measurement setups.

According to an aspect of the invention, the coupling capacitance of the universal artificial antenna is determined by coupling the universal artificial antenna to the calibration adapter, thereby obtaining the first measurement setup, and measuring a scattering parameter associated with the universal artificial antenna coupled to the calibration adapter.

Thus, the coupling capacitance of the universal artificial antenna is only based on one measured value, namely on the scattering parameter of the universal artificial antenna coupled to the calibration adapter, namely in the first measurement setup.

Hereinafter, the coupling capacitance relates to the capacitive coupling of the universal artificial antenna with regard to an electromagnetic coupling, particularly the transfer of energy within an electrical network or between distant networks by means of displacement current between nodes, induced by the electric field.

The scattering parameter is measured by means of a network analyzer that is connected to both the universal artificial antenna and the calibration adapter.

The scattering parameter associated with the universal artificial antenna coupled to the calibration adapter is a transmission factor. In specific, the transmission factor is the scattering parameter $S_{21}$. The transmission factor relates to a forward transmission factor or the forward voltage gain, representative for the transmission without excitation at port 2. Actually, the transmission factor defines the ratio of the output power wave at port 2 to the input power wave at port 1.

In other words, the coupling capacitance of the universal artificial antenna and the calibration adapter is based on the transmission factor, namely scattering parameter $S_{21}$, which is measured by the network analyzer.

In an aspect of the invention, the capacitance of the universal artificial antenna is based on the ratio of the scattering parameter associated with the universal artificial antenna coupled to the calibration adapter to the frequency of a measurement signal used, e.g. the scattering parameter measured in the first measurement setup. The scattering parameter itself depends on the frequency of the measurement signal used and, thus, the capacitance of the universal artificial antenna may also depend on the frequency of the measurement signal used. In other words, the capacitance of the universal artificial antenna is based on the scattering parameter associated with the universal artificial antenna coupled to the calibration adapter divided by $2\pi \cdot f$.

Therefore, the formula for calculating the coupling capacitance of the universal artificial antenna, which is coupled to the calibration adapter and which are both connected to the network analyzer can be expressed by the following equation:

$$C_k = \frac{S_{21,1}}{2\,\pi\,\cdot\,f} \cdot c$$

wherein $C_k$ is the capacitance of the universal artificial antenna, $S_{21,1}$ is the scattering parameter of the universal artificial antenna coupled to the calibration adapter, which is determined in the first measurement setup, $f$ is the frequency of the measurement signal used, and c is a proportionality constant.

The universal artificial antenna may comprise two 25 $\Omega$ resistors and a capacitor, and/or wherein the calibration adapter comprises two 25 $\Omega$ resistors.

In general, it is advisable to use a universal artificial antenna and a calibration adapter with the same number of resistors, particularly resistors with the same resistance. This gives an even distribution of the resistors and an overall symmetrical measurement setup for determining the coupling capacitance of the universal artificial antenna in a simplified manner.

Moreover, artificial antennas and calibration adapters having 25 $\Omega$ resistors are commonly used for calibrating of monopole antennas, e.g. by the ECSM known in the state of the art. These artificial antennas and calibration adapters may also be used for the method according to the invention, thereby reducing the efforts required since there is no need to use specific antennas or specific calibration adapters for the method according to the invention.

In a further aspect of the invention, an amplification of the matching device can be calculated by using the ratio of the scattering parameter associated with the universal artificial antenna to the scattering parameter associated with the calibration adapter.

Thus, the amplification and the input capacitance of the matching device can be determined easily based on scattering parameters.

Particularly, the input capacitance and the amplification of the matching device are directly proportional to the coupling capacitance of the universal artificial antenna.

In other words, a high coupling capacitance of the universal artificial antenna leads to a high input capacitance and amplification of the matching device, whereas a small coupling capacitance of the universal artificial antenna leads to a small input capacitance of the matching device.

According to another aspect of the invention, the input capacitance of the matching device is calculated based on the capacitance of the universal artificial antenna and the ratio of the scattering parameter associated with the universal artificial antenna (in the second measurement setup) to the scattering parameter associated with the calibration adapter (in the third measurement setup).

Specifically, the capacitance of the matching device may be calculated based on the formula:

$$C_e = \left(1 - \frac{|S_{21,3}|}{|S_{21,2}|}\right) \cdot C_k$$

wherein $C_e$ is the capacitance of the matching device, $S_{21,3}$ is the scattering parameter of the calibration adapter, which is determined in the third measurement setup, $S_{21,2}$ is the scattering parameter of the universal artificial antenna, which is determined in the second measurement setup, and $C_k$ is the coupling capacitance of the universal artificial antenna.

In other words, the input capacitance of the matching device can be calculated from the measurement of two scattering parameters, e.g. in two different measurement setups. As indicated above, the scattering parameters are measured with the network analyzer and the coupling capacitance of the universal artificial antenna used is the one previously calculated.

Overall, this formula describes the influence of the matching device on the scattering parameters of the calibration adapter and the universal artificial antenna in a measurement setup where the calibration adapter or the universal artificial antenna is connected to the matching device and to the network analyzer.

According to a further aspect of the invention, the matching device comprises at least a capacitor, an amplifier and an impedance. The capacitor is associated with an input of the matching device, thereby defining the (input) capacitance of the matching device.

The capacitance of the capacitor can be calculated using the above formula. The amplification of the amplifier can also be calculated.

The scattering parameter $S_{21,3}$ associated with the universal artificial antenna and used in the above formula is a transmission factor. This transmission factor is measured with the network analyzer coupled to the universal artificial antenna and the matching device, e.g. the third measurement setup. Thus, in the respective measurement setup, the network analyzer is connected to the universal artificial antenna, whereas the universal artificial antenna is connected to the matching device and the matching device is coupled to the network analyzer.

The scattering parameter $S_{21,2}$ associated with the calibration adapter is also a transmission factor. This transmission factor is also measured with the network analyzer, which is coupled to the calibration adaptor and the matching device, e.g. the second measurement setup. The second measurement setup is similar to the third measurement setup described above, for that the network analyzer being connected to the calibration adapter instead of the universal artificial antenna.

In another aspect of the invention, the capacitance of the monopole antenna is determined based on the capacitance of the matching device, the capacitance of the matching device, the scattering parameter associated with the universal artificial antenna, measured when the monopole antenna is connected with the matching device and the universal artificial antenna, and the scattering parameter associated with the calibration adapter, measured when the monopole antenna is connected with the matching device and the calibration adapter.

In other words, the capacitance of the monopole antenna can be calculated based on previously determined capacitances, e.g. coupling capacitance of the universal artificial antenna as well as the input capacitance of the matching device, and scattering parameters determined in different measurement setups, namely the scattering parameter associated with the universal artificial antenna in the fourth measurement setup and the scattering parameter associated with the calibration adapter in the fifth measurement setup.

The capacitance of the monopole antenna can be calculated based on the following formula:

$$C_a = \left[\left(1 - \frac{|S_{21,5}|}{|S_{21,4}|}\right) \cdot C_k\right] - C_e$$

**EP 4 703 740 A1**

wherein $C_a$ is the capacitance of the monopole antenna, $S_{21,5}$ is the scattering parameter associated with the calibration adapter, which is measured in the fifth measurement setup, $S_{21,4}$ is the scattering parameter associated with the universal artificial antenna, which is measured in the fourth measurement setup, $C_k$ is the coupling capacitance of the universal artificial antenna and $C_e$ is the input capacitance of the matching device.

Again, the coupling capacitance of the universal artificial antenna as well as the input capacitance of the matching device can be determined based on scattering parameters determined in different measurement setups, namely by using the above formulae.

It is therefore noted, that all the capacitances calculated within the method according to the invention are based only on measured scattering parameters, so that no further properties of the individual components, namely the monopole antenna, the matching device, the calibration adapter or the universal artificial antenna, are required to determine the antenna factor.

The monopole antenna may be connected in parallel with the universal artificial antenna.

The term "connected in parallel" is understood to denote that an input and an output port of the monopole antenna may be directly connected with an input and an output port of the universal artificial antenna by an electrical connection. Alternatively, the respective inputs and the respective outputs are connected to associated nodes, respectively. Therefore, the voltage is spit between the universal artificial antenna and the monopole antenna.

In another aspect of the invention, the antenna factor of the monopole antenna is corrected by using a correction factor, wherein the correction factor is calculated by two different ratios, wherein the ratios both depend on the capacitances of the matching device, the universal artificial antenna and the monopole antenna.

Correcting the antenna factor of the monopole antenna is necessary because the capacitance of the universal artificial antenna is not equal to the self-capacitance of the monopole antenna as it is the case e.g. for the ECSM.

In other words, the use of the correction factor allows the use of a universal artificial antenna so that one is not dependent on a specific artificial antenna which matches with the monopole antenna.

It should also be noted that the correction factor is calculated only on the basis of the previously calculated capacitances of the monopole antenna, the universal artificial antenna and the matching device. It is therefore not necessary to know any of these values in advance.

Another advantage is also that the correction factor is also indirectly based only on various measured scattering parameters, which can be measured accurately. This makes the whole method and the calibration of the monopole antenna less sensitive to measurement uncertainties.

In an embodiment of the invention, the correction factor is the product of the ratio of the capacitance of the universal artificial antenna to the sum of the capacitances of the universal artificial antenna and the adjustment unit; and the ratio of the sum of the capacitances of the monopole antenna and the adjustment unit to the capacitance of the monopole antenna.

This leads to the following formula for the correction factor:

$$K_c = \frac{C_k}{C_k + C_e} \cdot \frac{C_a + C_e}{C_a}$$

wherein, $K_c$ is the correction factor for correcting the mismatch between the capacitance of the universal artificial antenna and the capacitance of the monopole antenna, $C_k$ is the coupling capacitance of the universal artificial antenna, $C_e$ is the input capacitance of the matching device and $C_a$ is the capacitance of the monopole antenna.

According to a further aspect of the invention, the value of the capacitance of the monopole antenna which is used to calculate the correction factor is either based on the determined capacitances of the matching device, the universal artificial antenna and the monopole antenna or is calculated according to a geometric model.

The correction factor however can only be calculated by means of the geometric model for specific monopole antennas. In specific, the monopole antenna has to be a cylindrical monopole antenna.

The antenna factor of the monopole antenna may also depend on a height of the monopole antenna above ground potential.

Hereinafter, the "height of the monopole antenna" is the effective height of the monopole antenna relative to a ground.

According to the unsymmetrical nature of monopole antennas, a monopole antenna cannot suppress common mode currents at all. In contrast, symmetrical antennas with qualified baluns can suppress unwanted common mode effects. Therefore, monopole antennas are typically mounted on ground level or at least with low inductive and short grounding to the absorber lined shielded enclosure. In case, the monopole antenna has to be mounted distanced from the ground, a height correction of the monopole has to be done, in order to improve measurement uncertainties.

Further, the antenna factor also depends on the scattering parameter associated the universal artificial antenna coupled in parallel with the monopole antenna, namely in the fourth measurement setup.

This leads to the following final formula for calculating the antenna factor:

$$F_{ac}\left[\frac{dB}{m}\right] = 20 \cdot \log\frac{1}{|S_{21,4}|} - 20 \cdot \log(2) - 20 \cdot \log(h_e) + 20 \cdot \log(K_c)$$

wherein, $F_{ac}$ is the antenna factor, $S_{21,4}$ is the scattering parameter of the universal artificial antenna coupled to the monopole antenna, which is measured in the fourth measurement setup, $h_e$ is the effective height of the monopole antenna and $K_c$ is the correction factor as described above.

According to another aspect of the invention, the monopole antenna is fixed to a tripod or a ground plate during the measurement(s). This is needed, in order to determine the effective height of the monopole antenna and to be able to calculate the antenna factor correctly. However, for calculating the antenna factor, it does not make any difference, whether the monopole antenna is fixed to a tripod or a ground plate during measurement. For example, the monopole antenna can be mounted to a tripod in a height of 1 m.

DESCRIPTION OF THE DRAWINGS

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows an ECSM measurement arrangement for determining an antenna factor of a monopole antenna according to prior art;

- Figure 2 schematically shows an overview of components of a measurement arrangement according to an embodiment of the invention;

- Figure 3 schematically shows a first measurement setup of the measurement arrangement of Figure 2, which is used for determining a capacitance of the universal artificial antenna;

- Figure 4 schematically shows a coupling of a universal artificial antenna to a calibration adapter according to the first measurement setup of Figure 3;

- Figure 5 schematically shows a second measurement setup of the measurement arrangement of Figure 2, which is used for determining a capacitance of the matching device;

- Figure 6 schematically shows a third measurement setup of the measurement arrangement of Figure 2, which is used for determining a capacitance of the matching device,

- Figure 7 schematically shows the second measurement setup of Figure 5 as a circuit diagram,

- Figure 8 schematically shows the third measurement setup of Figure 7 as a circuit diagram;

- Figure 9 schematically shows a fourth measurement setup of the measurement arrangement of Figure 2, which is used for determining a capacitance of the matching device;

- Figure 10 schematically shows a fifth measurement setup of the measurement arrangement of Figure 2, which is used for determining a capacitance of the matching device according to the invention; and

- Figure 11 shows schematically a method for determining an antenna factor of a monopole antenna according to the invention, which is done by means of the measurement arrangement of Figure 2.

DETAILED DESCRIPTION

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the invention, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

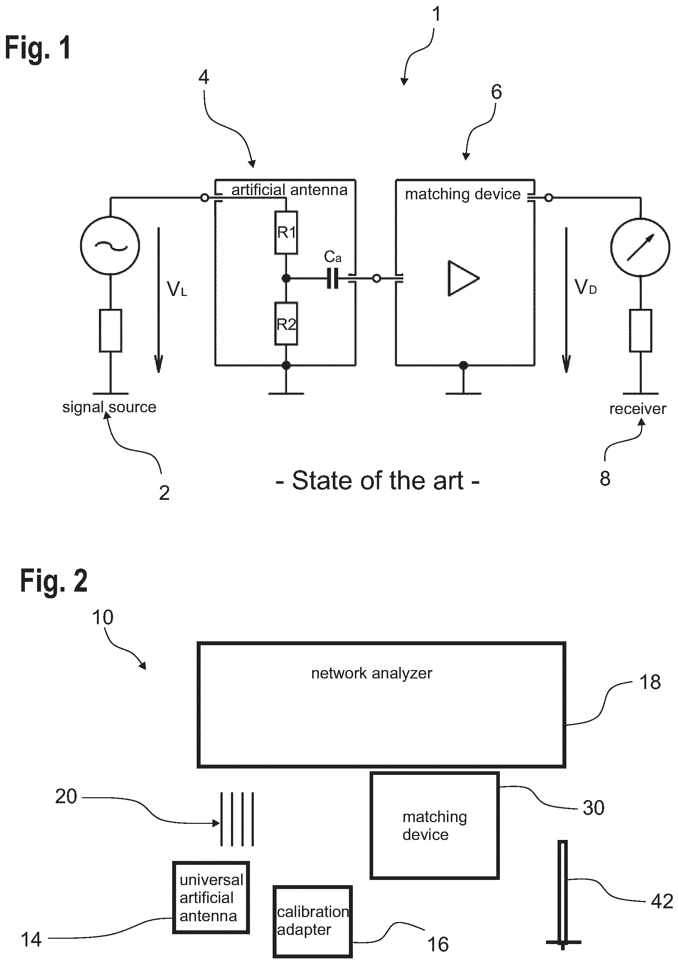

Figure 1 schematically shows a measurement arrangement 1 known in the state of the art, which is used for determining an antenna factor with an equivalent capacitor substitution method (ECSM).

The measurement arrangement 1 comprises a signal source 2, providing a signal, e.g. a voltage, an artificial antenna 4, replacing a monopole antenna, a matching device 6 with an amplifier and a receiver 8 which receives the signal, namely the voltage.

In the measurement arrangement 1, a monopole antenna is replaced by the artificial antenna 4 that has to correspond to the monopole antenna. Thus, the measurement is not performed with the monopole antenna itself, but with the specific artificial antenna 4.

The artificial antenna 4 comprises two resistors R1 and R2, each having a resistance of 25 $\Omega$, which are needed to incorporate a length of the common monopole antenna with the length of 1 m. The ratio of the resistors R1 and R2 is usually 1:1, such that a drive voltage $V_D$, originating from the signal source 2, is divided by the factor of 2, which corresponds to the height correction factor of the monopole antenna of 1 m length.

Further, the artificial antenna 4 comprises a capacitor $C_a$ which represents the self-capacitance of the monopole antenna. The self-capacitance of the monopole antenna among others depends on the length of the monopole antenna and/or the diameter of the monopole antenna.

Together with the matching device 6, a capacitive voltage divider is formed. The capacitive voltage divider is followed by an amplifier, which is also contained in the matching device 6. The amplifier has to deliver a $V_L$ into a 50 $\Omega$ load. The gain of the amplifier can be scaled such that an appropriate antenna factor ($F_A$) is obtained by the formula $F_A = V_D - V_L$.

Thus, in order to calibrate the monopole antenna according to the ECSM method, the artificial antenna 4 has to match with the monopole antenna, which should be calibrated. Therefore, for each monopole antenna a specific artificial antenna 4 is needed.

Moreover, since the height correction depends on the two resistors R1 and R2 of the artificial antenna 4, a height correction is only possible in a limited manner.

In addition, there are a number of uncertainties, which can negatively influence the determination of the antenna factor.

In Figures 2 to 10, a measurement arrangement 10 according to an embodiment of the invention is shown in different setups which are necessary for determining the antenna factor of a monopole antenna.

The measurement arrangement 10 comprises different components which are illustrated in Figure 2 in an isolated manner, wherein different measurement setups are established based on the components of the measurement arrangement 10 shown in Figure 2 as will be explained hereinafter in more detail.

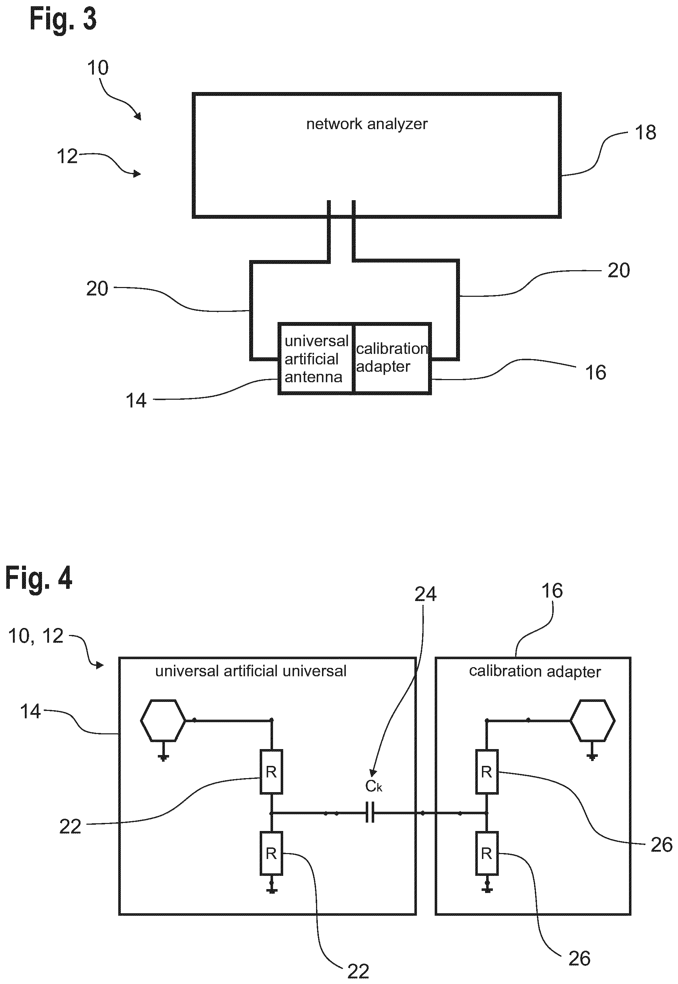

In a first measurement setup 12 of the measurement arrangement 10, which is shown in Figure 3, a universal artificial antenna 14 is coupled to a calibration adapter 16. The first measurement setup 12 is used to determine the coupling capacitance of the universal artificial antenna 14.

The universal artificial antenna 14 and the calibration adapter 16 are also connected to a network analyzer 18 by lines 20. In specific, one line 20 connects the universal artificial antenna 14 with a first port of the network analyzer 18, and a second line 20 connects the calibration adapter 16 with a second port of the network analyzer 18. The lines 20 may be realized by electrical conductors, for instance connection cables, particularly coaxial cables.

The network analyzer 18 provides a measurement signal via the first port or the second port which is received by the respective other port of the network analyzer 18. Then, the network analyzer 18 is enabled to analyze the signal received.

The network analyzer 18 is configured to determine a scattering parameter, S parameter, of the universal artificial antenna 14 coupled to the calibration adapter 16. Generally, the scattering parameter depends on a frequency of the measurement signal used.

In specific, the scattering parameter of the universal artificial antenna 14 and the calibration adapter 16 determined by the network analyzer 18 is a transmission factor, preferably the scattering parameter $S_{21}$.

Figure 4 schematically shows the coupling of the universal artificial antenna 14 with the calibration adapter 16 shown in Figure 3 in detail, thereby illustrating internal components of the universal artificial antenna 14 and the calibration adapter 16.

The universal artificial antenna 14 comprises two resistors 22, e.g. having a resistance of 25 $\Omega$, and a capacitor 24.

The two resistors 22 are connected in row.

The capacitor 24 of the universal artificial antenna 14 is connected to the connection between the two resistors 22, e.g. via a center tap.

The capacitor 24 may have a capacity of 15 pF. One side of the capacitor 24 is connected to the center tap located between both resistors 22, whereas the other side of the capacitor 24 is coupled to the calibration adaptor 16.

The calibration adaptor 16 comprises two resistors 26, e.g. having a resistance of 25 Ω, which are also connected in row. The calibration adaptor 16 has an interface via which the calibration adaptor 16 is connected to the universal artificial antenna 14, wherein the interface is associated with a center tap located between both resistors 26.

The overall arrangement of the of the two resistors 22 of the universal artificial antenna 14 and the two resistors 26 of the calibration adapter 16 is symmetrical with the capacitor 24 of the universal artificial antenna 14 in the center.

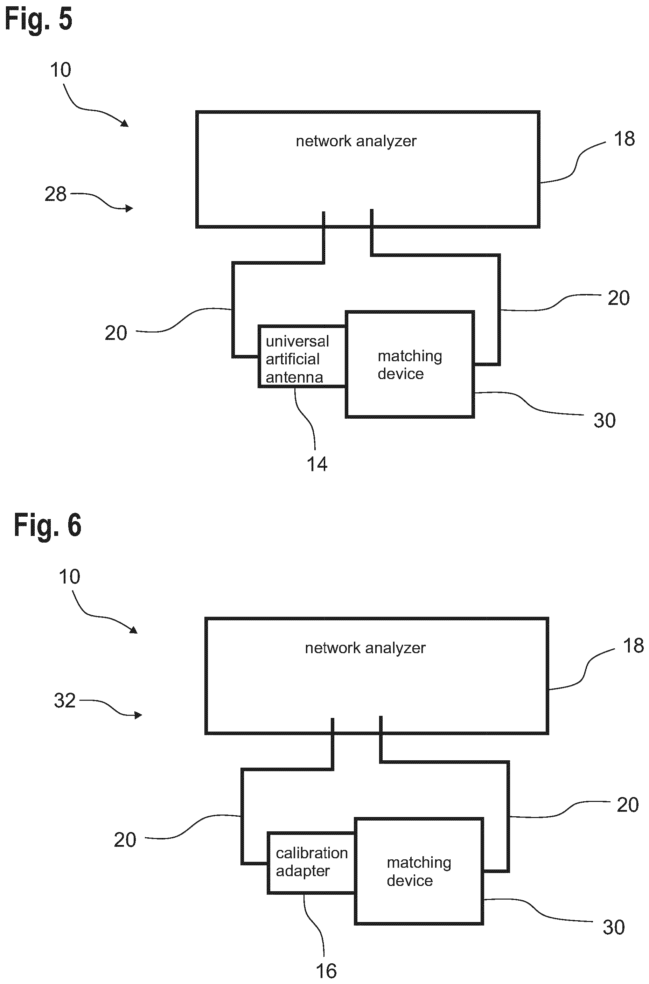

Figure 5 schematically shows a second measurement setup 28, which comprises the universal artificial antenna 14 and the network analyzer 18. However, in the second measurement setup 28, the universal artificial antenna 14 is connected to a matching device 30 instead of the calibration adapter 16. In other words, the calibration adapter 16 used in the first measurement setup 12 was replaced by the matching device 30.

In the second measurement setup 28, a first port of the network analyzer 18 is connected to the universal artificial antenna 14, whereas the second port of the network analyzer 18 is connected to the matching device 30.

With this second measurement setup 28, the influence of the matching device 30 on the scattering factors of the universal artificial antenna 14 can be determined.

In other words, a scattering parameter associated with the universal artificial antenna 14 is measured in the second measurement setup 28. Based on the scattering parameter associated with the universal artificial antenna 14, a capacitance of the matching device 30 can be determined as will be discussed later in more detail.

The scattering parameter associated with the universal artificial antenna 14 measured in the second measurement setup 28 is again a transmission factor, namely the S-parameter $S_{21}$.

As it is shown in Figure 6, a third measurement setup 32 is similar to the second measurement setup 28. The only difference between both setups 28, 32 is that, in the third measurement setup 32, the matching device 30 is coupled to the calibration adapter 16 instead of the universal artificial antenna 14. In other words, the calibration adapter 16 has replaced the universal artificial antenna 14 in the third measurement setup 32 with respect to the second measurement setup 28.

With the third measurement setup 32, the influence of the matching device 30 on the scattering factors of the calibration adapter 16 can be determined.

In other words, a scattering parameter associated with the calibration adapter 16 is measured in the third measurement setup 32. Based on the scattering parameter associated with the calibration adapter 16, a capacitance of the matching device 30 can be determined as will be discussed later in more detail.

The scattering parameter associated with the calibration adapter 16 measured in the third measurement setup 32 is again a transmission factor, namely the S-parameter $S_{21}$.

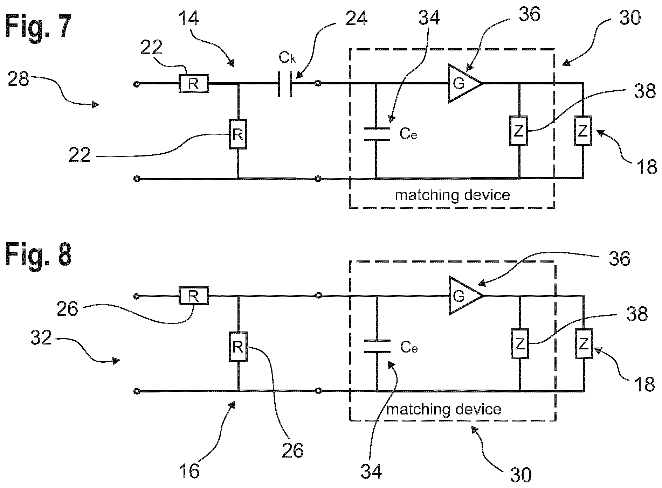

In figure 7, the second measurement setup 28 with the universal artificial antenna 14 coupled to the matching device 30 is shown as a circuit diagram, whereas the third measurement setup 32 with the calibration adapter 16 coupled to the matching device 30 is shown in Figure 8 as a circuit diagram.

As shown in Figures 7 and 8, the matching device 30 comprises a capacitor 34, e.g. an input capacitor, the capacitance of which is determined by the second measurement setup 28 and third measurement setup 32.

Further, the matching device 30 comprises an amplifier 36 and an adjustable impedance 38. The amplification of the amplifier 36 may also be determined by the second measurement setup 28 and third measurement setup 32.

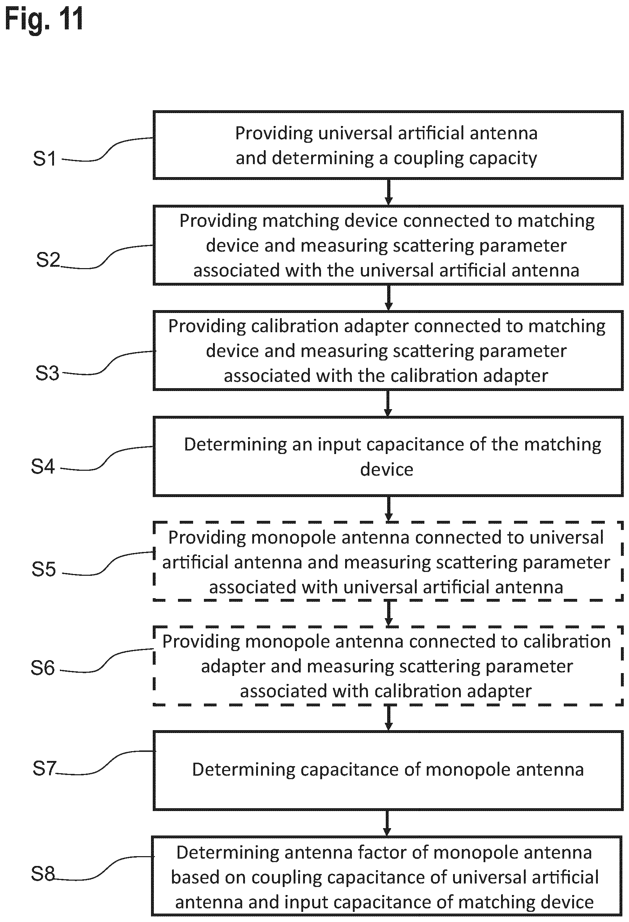

The scattering parameters determined in the second measurement setup 28 and the third measurement setup 32 are used to calculate the input capacitance of the matching device 30, namely the capacitance of capacitor 34, as will be described later when referring to Figure 11.

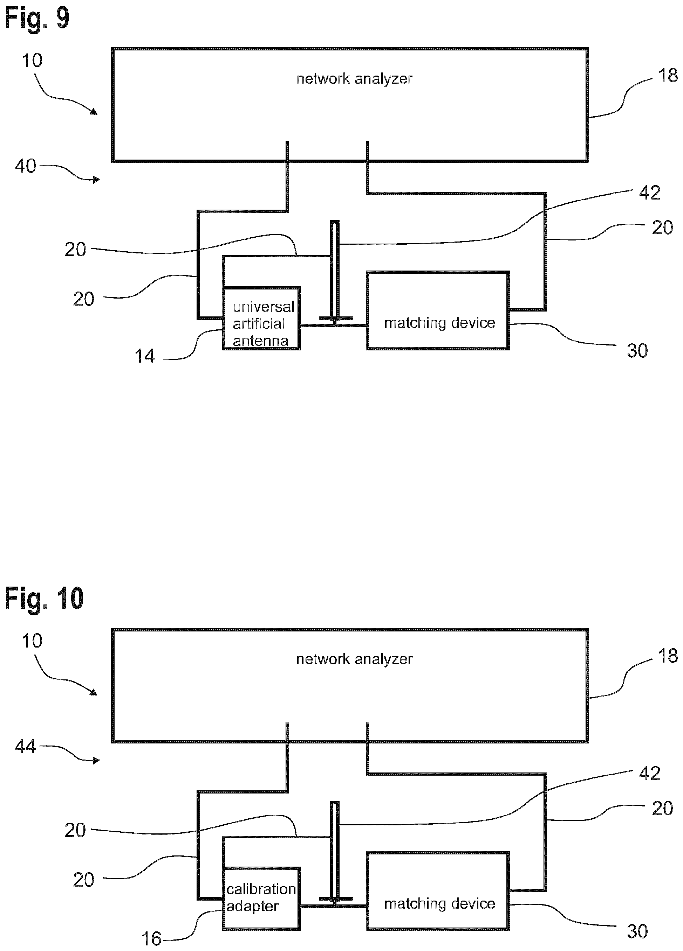

Figure 9 schematically shows a fourth measurement setup 40 of the measurement arrangement 10, which is used to measure a scattering factor based on which the capacitance of the monopole antenna 42 can be determined.

The fourth measurement setup 40 is similar to the second measurement setup 28 shown in Figure 5. In addition to the components of the second measurement setup 28, the fourth measurement setup 40 additionally comprises the monopole antenna 42.

The monopole antenna 42 is connected in parallel to the universal artificial antenna 14. The monopole antenna 42 and the universal artificial antenna 14 are connected with each other by a line 20.

By connecting the monopole antenna 42 in parallel to the universal artificial antenna 14, the antenna factor can be correctly calculated in a simplified manner, thereby being enabled to calibrate the monopole antenna 42 more easily.

The monopole antenna 42 can be mounted either on a tripod and a ground plate (not shown) or directly on the ground plate which is placed on the ground. The tripod can have a height of 1 m.

In the fourth measurement setup 40, the network analyzer 18 measures the scattering parameter associated with the universal artificial antenna 14 in the respective measurement setup 40.

Based on the measured scattering parameter, which is again the transmission factor, namely S-parameter $S_{21}$, conclusions can be drawn on the capacitance of the monopole antenna 42.

In order to calculate the capacitance of the monopole antenna 42, a further measurement has to be performed in a fifth measurement setup 44 which is shown in Figure 10.

The fifth measurement setup 44 is similar to the fourth measurement setup 40, but the universal artificial antenna 14 has been replaced by the calibration adapter 16 in the fifth measurement setup 44.

Thus, in the fifth measurement setup 44 the calibration adapter 16 is connected in parallel to the monopole antenna 42 instead of the universal artificial antenna 14 as it was the case in the fourth measurement setup 40.

The fifth measurement setup 44 is used to determine the scattering parameter associated with the calibration adapter 16, which is the transmission factor, namely S-parameter $S_{21}$, of the calibration adapter 16.

Based on the ratio of the scattering parameter associated with the calibration adapter 16, obtained by the fifth measurement setup 44, to the scattering parameter associated with the universal artificial antenna 14, obtained by the fourth measurement setup 40, together with the coupling capacitance of the universal artificial antenna 14 and the input capacitance of the calibration adapter 16, the capacitance of the monopole antenna 42 can be calculated. The different calculated capacitances are afterwards used to calculate the antenna factor of the monopole antenna 42. This becomes clear hereinafter while referring to the method for determining the antenna factor of the monopole antenna 42, which is shown in Figure 11. Based thereon the monopole antenna 42 can be calibrated.

In a first step S1, a universal artificial antenna 14 is provided and the coupling capacitance of the universal artificial antenna 14 is determined. Therefore, the first measurement setup 12, shown in Figure 3, is used, in which the universal artificial antenna 14 is coupled to the calibration adapter 16. Further, the network analyzer 18 is connected with the universal artificial antenna 14 and the calibration adapter 16. The scattering parameter associated with the universal artificial antenna 14 coupled to the calibration adapter 16 is determined by the network analyzer 18, namely the scattering parameter associated with the universal artificial antenna 14 in the first measurement setup 12.

The coupling capacitance of the universal artificial antenna 14 is based on the ratio of the scattering parameter associated with the universal artificial antenna 14 coupled to the calibration adapter 16 to the frequency of a measurement signal used.

Therefore, the formula for calculating the coupling capacitance of the universal artificial antenna 14 is the following:

$$C_k = \frac{S_{21}}{2\,\pi\,\cdot f} \cdot c$$

wherein $C_k$ is the coupling capacitance of the universal artificial antenna 14 and $S_{21,1}$ is the scattering parameter associated with the universal artificial antenna 14 coupled to the calibration adapter 16, namely the scattering parameter obtained in the first measurement setup 12. In addition, a proportionality constant c is used.

In a second step S2, the matching device 30 of the measurement arrangement 10 is provided. The matching device 30 is connected with the universal artificial antenna 14, thereby replacing the calibration adapter 16. Hence, the second measurement setup 28 shown in Figure 5 is obtained. In the second measurement setup 28, the scattering parameter associated with the universal artificial antenna 14 is measured by the network analyzer 18.

In a third step S3, the calibration adapter 16 of the measurement arrangement 10 is provided and the matching device 30 is connected to the calibration adapter 16 which replaces the universal artificial antenna 14, thereby obtaining the third measurement setup 32 shown in Figure 6. In the third measurement setup 32, the scattering parameter associated with the calibration adapter 16 is determined by the network analyzer 18.

Based on the information already gathered, the input capacitance and the amplification of the matching device 30 can be determined, particularly calculated, in a fourth step S4.

Actually, the input capacitance of the matching device 30 can be determined based on the coupling capacitance of the universal artificial antenna 14, determined based on the first measurement setup 12, as well as the ratio of the scattering parameter associated with the universal artificial antenna 14, obtained in the second measurement setup 28, to the scattering parameter associated with the calibration adapter 16, obtained in the third measurement setup 32, as well as.

Specifically, the input capacitance of the matching device 30 can be calculated with the following formula

$$C_e = \left(1 - \frac{|S_{21,3}|}{|S_{21,2}|}\right) \cdot C_k$$

wherein $C_e$ is the input capacitance of the matching device 30, $S_{21,3}$ is the scattering parameter of the calibration adapter 16, obtained in the third measurement setup 32, $S_{21,2}$ is the scattering parameter of the universal artificial antenna 14, obtained in the second measurement setup 28, and $C_k$ is the coupling capacitance of the universal artificial antenna 14. Hence, the input capacitance of the matching device 30 is directly proportional to the coupling capacitance of the universal artificial antenna 14.

In a fifth step S5, the monopole antenna 42 of the measurement arrangement 10 is provided and connected to the matching device 30 and the universal artificial antenna 14, thereby providing the fourth measurement setup 40 shown in Figure 9. Then, the scattering parameter associated with the universal artificial antenna 14 is measured by the network analyzer 18 in the fourth measurement setup 40.

In a sixth step S6, the monopole antenna 42 is provided and connected to the matching device 30 and the calibration adapter 16. In other words, the universal artificial antenna 14 was replaced in by the calibration adapter 16, thereby obtaining the fifth measurement setup 44 shown in Figure 10.

In the sixth step, the scattering parameter associated with the calibration adapter 16 is measured by the network analyzer 18 in the fifth measurement setup 44.

In a seventh step S7, the capacitance of the monopole antenna 42 can be calculated based on the coupling capacitance of the universal artificial antenna 14 calculated in the first step, the input capacitance of the matching device 30 calculated in the fourth step and the ratio of the scattering parameter associated with the universal artificial antenna 14 measured in the fifth step to the scattering parameter associated with the calibration adapter 16 measured in the sixth step.

The corresponding formula for calculating the capacitance of the monopole antenna 42 is the following:

$$C_a = \left[ \left( 1 - \frac{|S_{21,5}|}{|S_{21,4}|} \right) \cdot C_k \right] - C_e$$

wherein $C_a$ is the capacitance of the monopole antenna 42, $S_{21,5}$ is the scattering parameter associated with the calibration adapter 16, obtained in the fifth measurement setup 44, $S_{21,4}$ is the scattering parameter associated with the universal artificial antenna 14, obtained in the fourth measurement setup 40, $C_k$ is the coupling capacitance of the universal artificial antenna 14 and $C_e$ is the input capacitance of the matching device 30.

Alternatively to determining the capacitance of the monopole antenna 42 as outlined above, e.g. by means of the fifth step sixth step, the capacitance of the monopole antenna 42 may be determined by means of a geometric model. This however typically only works for specific monopole antennas, namely cylindrical monopole antennas.

In an eighth step, the antenna factor of the monopole antenna 42 Is determined based on the capacitance of the monopole antenna 42, the coupling capacitance of the universal artificial antenna 14 and the input capacitance of the matching device 30.

For the formula for calculating the antenna factor of the monopole antenna 42, a correction factor is taken into account since the capacitance of the universal artificial antenna 14 is not equal to the self-capacitance of the monopole antenna 42.

This correction factor is called $K_c$ and can be calculated as follows:

$$K_c = \frac{C_k}{C_k + C_e} \cdot \frac{C_a + C_e}{C_a}$$

wherein, $C_k$ is the coupling capacitance of the universal artificial antenna, $C_e$ is the input capacitance of the matching device and $C_a$ is the capacitance of the monopole antenna.

Thus, the correction factor is the product of two different ratios of capacitances of the matching device 30, the universal artificial antenna 14 and the calibration adapter 16.

The capacitance of the monopole antenna 42, used to calculate the correction factor, can either be based on the determined capacitances of the monopole antenna 42, the universal artificial antenna 14 and the calibration adaptor 16 or it can be calculated according to a geometric model as indicated above.

As the antenna factor also depends on the height of the monopole antenna 42 above ground potential, the monopole antenna 42 can be fixed to a tripod or a ground plate 46 during the measurements, especially during the measurements in the fifth step and the sixth step, the effective height of the monopole antenna 42 also has to be included to the formula.

Therefore, the final formula to calculate the antenna factor of a monopole antenna 42 is the following:

$$F_{ac} \left[ \frac{dB}{m} \right] = 20 \cdot \log \frac{1}{|S_{21,4}|} - 20 \cdot \log(2) - 20 \cdot \log(h_e) + 20 \cdot \log(K_c)$$

wherein, $F_{ac}$ is the antenna factor, $S_{21,4}$ is the scattering parameter of the universal artificial antenna 14 coupled to the monopole antenna 42, which is measured in the fourth measurement setup 40, $h_e$ is the effective height of the monopole antenna and $K_c$ is the correction factor.

The method according to the invention enables the reliable determination of the antenna factor and the calibration of monopole antennas based on the measurement of scattering parameters with a network analyzer.

Certain embodiments disclosed herein, particularly the respective module(s) and/or unit(s), and/or device(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A method for determining an antenna factor of a monopole antenna (42), the method comprising the following steps:

   - providing a universal artificial antenna (14) and determining a coupling capacitance of the universal artificial antenna (14);
   - providing a matching device (30), connecting the matching device (30) with the universal artificial antenna (14), and measuring a scattering parameter associated with the universal artificial antenna (14),
   - providing a calibration adapter (16), connecting the matching device (30) with the calibration adapter (16) such that the calibration adapter (16) replaces the universal artificial antenna (14), and measuring a scattering parameter associated with the calibration adapter (16),
   - determining an input capacitance of the matching device (30) using the ratio of the scattering parameter associated with the universal artificial antenna (14) to the scattering parameter associated with the calibration adapter (16);
   - providing a monopole antenna (42), connecting the monopole antenna (42) with the matching device (30) and the universal artificial antenna (14), and measuring a scattering parameter associated with the universal artificial antenna (14);
   - providing the calibration adapter (16), connecting the monopole antenna (42) with the matching device (30) and the calibration adapter (16) such that the calibration adapter (16) replaces the universal artificial antenna (14), and measuring a scattering parameter associated with the calibration adapter (16);
   - determining a capacitance of the monopole antenna (42) based on a geometric model of the monopole antenna (42) or based on the coupling capacitance of the universal artificial antenna (14), the input capacitance of the matching device (30), and the ratio of the scattering parameter associated with the universal artificial antenna (14) to the scattering parameter associated with the calibration adapter (16); and
   - determining the antenna factor of the monopole antenna (42) based on the capacitance of the monopole antenna (42), the coupling capacitance of the universal artificial antenna (14) and the input capacitance of the matching device (30).

2. The method according to claim 1, wherein the coupling capacitance of the universal artificial antenna (14) is determined by coupling the universal artificial antenna (14) to the calibration adapter (16), and measuring a scattering parameter associated with the universal artificial antenna (14) coupled to the calibration adapter (16).

3. The method according to one of the claims 1 or 2, wherein the scattering parameter associated with the universal artificial antenna (14) coupled to the calibration adapter (16) is a transmission factor.

4. The method according to one of the preceding claims, wherein the capacitance of the universal artificial antenna (14) is based on the ratio of the scattering parameter associated with the universal artificial antenna (14) coupled to the calibration adapter (16) to the frequency of a measurement signal used.

5. The method according to one of the preceding claims, wherein the universal artificial antenna (14) comprises two 25 $\Omega$ resistors and a capacitor, and/or wherein the calibration adapter (16) comprises two 25 $\Omega$ resistors.

6. The method according to one of the preceding claims, wherein an amplification of the matching device (30) is also determined by using the ratio of the scattering parameter associated with the universal artificial antenna (14) to the scattering parameter associated with the calibration adapter (16), in particular wherein the input capacitance and the amplification of the matching device (30) are directly proportional to the capacitance of the universal artificial antenna (14).

7. The method according to one of the preceding claims, wherein the input capacitance of the matching device (30) is determined based on the capacitance of the universal artificial antenna (14) and the ratio of the scattering parameter associated with the universal artificial antenna (14) to the scattering parameter associated with the calibration adapter (16).

8. The method according to one of the preceding claims, wherein the matching device (30) comprises at least a capacitor, an amplifier and an impedance.

9. The method according to one of the preceding claims, wherein the scattering parameter associated with the universal artificial antenna is a transmission factor and/or wherein the scattering parameter associated with the calibration adapter (16) is a transmission factor.

10. The method according to one of the preceding claims, wherein the capacitance of the monopole antenna (42) is determined based on the capacitance of the matching device (30), the capacitance of the matching device (30), the scattering parameter associated with the universal artificial antenna (14), measured when the monopole antenna (42) is connected with the matching device (30) and the universal artificial antenna (14), and the scattering parameter associated with the calibration adapter (16), measured when the monopole antenna (42) is connected with the matching device (30) and the calibration adapter (16).

11. The method according to one of the preceding claims, wherein the monopole antenna (42) is connected in parallel to the universal artificial antenna (14).

12. The method according to one of the preceding claims, wherein the antenna factor of the monopole antenna (42) is corrected by using a correction factor, wherein the correction factor is determined by two different ratios, wherein the ratios both depend on the capacitances of the matching device (30), the universal artificial antenna (14) and the monopole antenna (42), in particular wherein the correction factor is the product of the ratio of the capacitance of the universal artificial antenna (14) to the sum of the capacitances of the universal artificial antenna (14) and the adjustment unit; and the ratio of the sum of the capacitances of the monopole antenna (42) and the adjustment unit to the capacitance of the monopole antenna (42), in particular wherein the value of the capacitance of the monopole antenna (42) which is used to determine the correction factor is either based on determined capacitances of the matching device (30), the universal artificial antenna (14) and the monopole antenna (42) or is determined according to a geometric model.

13. The method according to one of the preceding claims 1, wherein the antenna factor of the monopole antenna (42) also depends on a height of the monopole antenna (42) above ground potential.

14. The method according to one of the preceding claims, wherein the monopole antenna (42) is fixed to a tripod or a ground plate during the measurement.

15. A measurement arrangement (10) for determining an antenna factor of a monopole antenna, wherein the measurement arrangement (10) having different measurement setups, wherein the measurement arrangement (10) comprises a universal artificial antenna (14), a calibration adapter (16), a matching device (30), a monopole antenna (42) and a network analyzer (18),

wherein, in a first measurement setup (12) for determining the capacitance of the universal artificial antenna (14), the universal artificial antenna (14) is coupled to the calibration adapter (16);

wherein, in a second measurement setup for measuring the scattering parameter associated with the universal artificial antenna (14), the matching device (30) is coupled to the universal artificial antenna (14), and the matching device (30) and the artificial antenna (14) being coupled to the network analyzer (18);

wherein, in a third measurement setup for measuring the scattering parameter associated with the calibration adapter (16), the matching device (30) is coupled to the calibration adapter (16), and the matching device (30) and the calibration adapter (16) being coupled to the network analyzer (18);

wherein, in a fourth measurement setup for measuring the scattering parameter associated with the universal artificial antenna (14), the matching device (30) being coupled to the monopole antenna (42), the universal artificial antenna (14) being coupled to the monopole antenna (42), and the universal artificial antenna (14) and the matching device (30) being coupled to the network analyzer (18); and

wherein, in a fifth measurement setup for measuring the scattering parameter associated with the calibration adapter (16), the matching device (30) being coupled to the monopole antenna (42), the calibration adapter (16) being coupled to the monopole antenna (42), and the calibration adapter (16) and the matching device (30) being coupled to the network analyzer (18).

## Fig. 1

- State of the art -

## Fig. 2

## Fig. 3

## Fig. 4

## Fig. 5

10

28

network analyzer

18

20

20

universal artificial antenna

matching device

14

30

## Fig. 6

10

32

network analyzer

18

20

20

calibration adapter

matching device

16

30

**Fig. 7**

matching device

**Fig. 8**

matching device

## Fig. 9

10

40

18

42

20

20

20

14

network analyzer

universal artificial antenna

matching device

30

## Fig. 10

10

44

18

42

20

20

20

16

network analyzer

calibration adapter

matching device

30

# Fig. 11

S1 — 
Providing universal artificial antenna
and determining a coupling capacity

S2 — 
Providing matching device connected to matching
device and measuring scattering parameter
associated with the universal artificial antenna

S3 — 
Providing calibration adapter connected to matching
device and measuring scattering parameter
associated with the calibration adapter

S4 — 
Determining an input capacitance of the matching
device

S5 — 
Providing monopole antenna connected to universal
artificial antenna and measuring scattering parameter
associated with universal artificial antenna

S6 — 
Providing monopole antenna connected to calibration
adapter and measuring scattering parameter
associated with calibration adapter

S7 — 
Determining capacitance of monopole antenna

S8 — 
Determining antenna factor of monopole antenna
based on coupling capacitance of universal artificial
antenna and input capacitance of matching device

Europäisches
Patentamt

European
Patent Office

Office européen
des brevets

# EUROPEAN SEARCH REPORT

**Application Number**

EP 25 18 7838

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ISHII M ET AL: "A reference antenna method for non-resonant electrically short monopole antennas", ELECTROMAGNETIC COMPATIBILITY (EMC), 2010 IEEE INTERNATIONAL SYMPOSIUM ON, IEEE, 25 July 2010 (2010-07-25), pages 56-61, XP031978486, DOI: 10.1109/ISEMC.2010.5711247 ISBN: 978-1-4244-6305-3 * paragraphs [00II] - [00IV]; figures 1-3 * | 1-15 | INV. G01R29/10 H04B17/12 |
| A | ZHENFEIL SONG ET AL: "Capacitance correction factor of Equivalent Capacitor Substitution Method (ECSM) for monopole antenna calibration", PROCEEDINGS OF 2014 3RD ASIA-PACIFIC CONFERENCE ON ANTENNAS AND PROPAGATION, IEEE, 26 July 2014 (2014-07-26), pages 924-927, XP032710547, DOI: 10.1109/APCAP.2014.6992652 [retrieved on 2014-12-18] * paragraphs [000I] - [0III]; figure 1 * | 1-15 | |
| A | MASANORI ISHII ET AL: "Comparison between three-antenna method and equivalent capacitance substitution method for calibrating electrically short monopole antenna", ELECTROMAGNETIC COMPATIBILITY (EMC), 2011 IEEE INTERNATIONAL SYMPOSIUM ON, IEEE, 14 August 2011 (2011-08-14), pages 101-106, XP032057408, DOI: 10.1109/ISEMC.2011.6038292 ISBN: 978-1-4577-0812-1 * paragraphs [000I] - [00VI]; figures 1-5 * | 1-15 | TECHNICAL FIELDS SEARCHED (IPC) G01R H04B |

-/--

The present search report has been drawn up for all claims

| Place of search | Date of completion of the search | Examiner |
|---|---|---|
| Munich | 5 December 2025 | Maric, Viktor |

EPO FORM 1503 03.82 (P04C01)

# EP 4 703 740 A1

**EUROPEAN SEARCH REPORT**

Europäisches
Patentamt
European
Patent Office
Office européen
des brevets

**Application Number**

EP 25 18 7838

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | AKIRA SUGIURA ET AL: "Equivalent capacitance substitution method for monopole antenna calibration", ELECTROMAGNETIC COMPATIBILITY (EMC), 2012 IEEE INTERNATIONAL SYMPOSIUM ON, IEEE, 6 August 2012 (2012-08-06), pages 708-713, XP032468167, DOI: 10.1109/ISEMC.2012.6351647 ISBN: 978-1-4673-2061-0 * paragraphs [000I] - [00IV]; figures 1-8 * | 1-15 | |

-----

TECHNICAL FIELDS
SEARCHED        (IPC)

The present search report has been drawn up for all claims

| Place of search | Date of completion of the search | Examiner |
|---|---|---|
| Munich | 5 December 2025 | Maric, Viktor |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)